# EUROPEAN PATENT APPLICATION

(11) **EP 1 914 802 A2**
(43) Date of publication of application: **23.04.2008**
(21) Application number: 07016072.6
(22) Date of filing: 16.08.2007
(51) Int. Cl.: H01L 21/84

(54) **Method of producing thin film transistor substrate**

(30) Priority: 18.10.2006 KR 20060101428
(71) Applicant: Samsung Electronics Co., Ltd., Yeongtong-gu Suwon-city, Gyeonggi-do 442-742 (KR)
(72) Inventor: Choi, Seung-ha, Siheung-si, Gyeonggi-do (KR); Kim, Sang-gab, Gangdong-du, Seoul (KE); Oh, Min-seok, Yongin-si, Gyeonggi-do (KR); Choi, Shin-il, Gwanak-gu, Seoul (KR); Kim, Dae-ok, Osan-si, Gyeonggi-do (KR); Chin, Hong-kee, Suwon-si, Gyeonggi-do (KR); Jeong, Young-ho, Hwaseong-si, Gyeonggi-do (KR); Jeong, Yu-gwang, Yongin-si, Gyeonggi-do (KR)
(74) Representative: Weitzel, Wolfgang

(57) **Abstract**

A method of producing a thin film transistor substrate to prevent an interconnection from being corroded during a dry etching process includes sequentially forming on an insulating substrate a gate interconnection, a gate insulating layer, an active layer, a conductive layer for a data interconnection, and a photoresist pattern including a first region and a second region, etching the conductive layer for the data interconnection using the photoresist pattern as an etching mask to form a conductive layer pattern for source/drain electrodes, etching the active layer using the photoresist pattern as the etching mask to form an active layer pattern, removing the second region of the photoresist pattern, dry etching the conductive layer pattern for the source/drain electrodes under the second region using the photoresist pattern as the etching mask and etching gas, etching a portion of the active layer pattern using the photoresist pattern as the etching mask, and physically removing the reaction byproduct using a reaction byproduct removal agent so that external force is applied to the etching gas and the reaction byproduct of the conductive layer pattern for the source/drain electrodes.

## Description

### BACKGROUND OF THE INVENTION

### Field of the Invention

The present invention relates to a method of producing a thin film transistor substrate and, more particularly, to a method of producing a thin film transistor substrate that prevents corrosion of data interconnections during a dry etching process.

### Description of the Related Art

Currently, the liquid crystal display (LCD) is one of the most commonly used flat panel displays. The liquid crystal display is provided with two substrates on which electrodes are formed. A liquid crystal layer is interposed between the substrates. In the liquid crystal display, voltage is applied to the electrodes to rearrange liquid crystal molecules of the liquid crystal layer, thereby controlling the quantity of transmitted light. Recently, demands for large liquid crystal displays having high resolution are growing.

Of the two substrates that constitute the liquid crystal display, the thin film transistor substrate includes a plurality of pixel electrodes provided in a matrix form. Alternatively, one common electrode may cover an entire surface of the substrate. The thin film transistor substrate includes a plurality of gate interconnections for displaying images and data interconnections for transferring voltage to be applied to the pixel electrodes.

Forming the data interconnections includes an etching process which may include wet etching or dry etching. It is impossible to produce liquid crystal displays having high resolution using wet etching since its isotropic nature skews data interconnection.

Dry etching is problematic because it generates byproducts of reaction that corrode the data interconnections, causing a nonuniform connection pattern or the breaking of the data interconnections.

Accordingly, it is necessary to prevent the skew or corrosion of the data interconnections.

### SUMMARY OF THE INVENTION

According to an aspect of the present invention a thin film transistor substrate is produced by a method which prevents data interconnections from being corroded during the dry etching process.

According to an aspect of the present invention, a method of producing a thin film transistor substrate includes sequentially forming on an insulating substrate a gate interconnection, a gate insulating layer, an active layer, a conductive layer for a data interconnection, and a photoresist pattern including a first region and a second region, etching the conductive layer for the data interconnection by using the photoresist pattern as an etching mask to form a conductive layer pattern for source/drain electrodes and a data line, etching the active layer by using the photoresist pattern as the etching mask to form an active layer pattern, removing the second region of the photoresist pattern, dry etching the conductive layer pattern for the source/drain electrodes under the second region by using the photoresist pattern as the etching mask and etching gas, etching a portion of the active layer pattern by using the photoresist pattern as the etching mask, and physically removing the reaction byproduct by using a reaction byproduct removal agent so that external force is applied to the etching gas and the reaction byproduct of the conductive layer pattern for the source/drain electrodes.

According to another embodiment of the present invention, a method of producing a thin film transistor substrate includes sequentially forming on an insulating substrate a gate interconnection, a gate insulating layer, an active layer, a conductive layer for a data interconnection including aluminum, and a photoresist pattern including a first region and a second region, etching the conductive layer for the data interconnection by using the photoresist pattern as an etching mask to form a conductive layer pattern for source/drain electrodes, etching the active layer by using the photoresist pattern as the etching mask to form an active layer pattern, removing the second region of the photoresist pattern, dry etching the conductive layer pattern for the source/drain electrodes under the second region by using the photoresist pattern as the etching mask and chlorine-based etching gas, etching a portion of the active layer pattern by using the photoresist pattern as the etching mask, and spraying a reaction byproduct removal agent onto the etching gas and the reaction byproduct of the conductive layer pattern for the source/drain electrodes to remove the reaction byproduct.

### BRIEF DESCRIPTION OF THE DRAWINGS

The above and other features and advantages of the present invention will become more apparent by describing in detail preferred embodiments thereof with reference to the attached drawings, in which:

FIG. 1 is a layout view of a thin film transistor substrate that is produced using a method of producing the thin film transistor substrate according to embodiments of the present invention;

FIG. 2 is a sectional view of the thin film transistor substrate taken along the line A-A' of FIG. 1 ;

FIGS. 3 to 13 are sectional views showing the production of the thin film transistor substrate according to a first embodiment of the present invention; and

FIG. 14 schematically shows the production of the thin film transistor substrate according to a second embodiment of the present invention.

### DESCRIPTION OF THE EXEMPLARY EMBODIMENTS

It will be understood that when an element or layer is referred to as being "on" another element or layer, it can be directly on to the other element or layer or intervening elements or layers may be present. In contrast, when an element is referred to as being "directly on" another element or layer, there are no intervening elements or layers present. Like reference numerals refer to like elements throughout the specification.

Spatially relative terms, such as "below", "beneath", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. Like reference numerals refer to like elements throughout the specification.

Hereinafter, embodiments of the present invention will be described in detail with reference to the accompanying drawings. Methods of producing the thin film transistor substrate according to the following embodiments may be applied to produce all image display devices that include thin film transistors. For convenience of the description, however, liquid crystal displays are disclosed as the image display devices using the methods of producing the thin film transistor substrate according to the embodiments of the present invention. In connection with this, the liquid crystal display includes a thin film transistor substrate in which the thin film transistor array is formed, a common electrode substrate which faces the thin film transistor substrate and in which a common electrode is formed, and a liquid crystal layer that is interposed between the substrates.

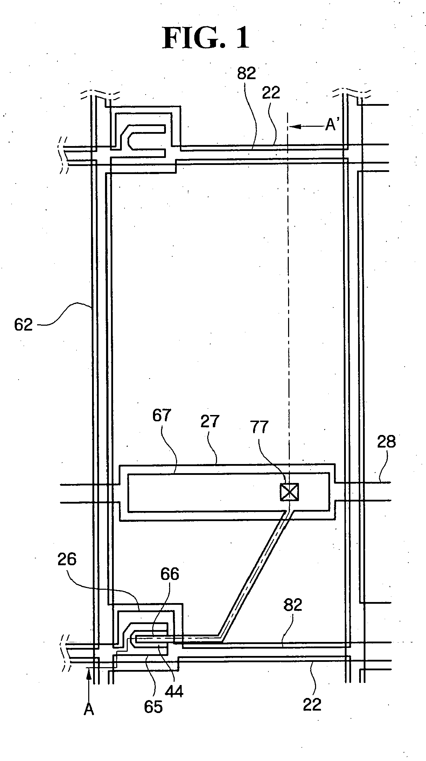

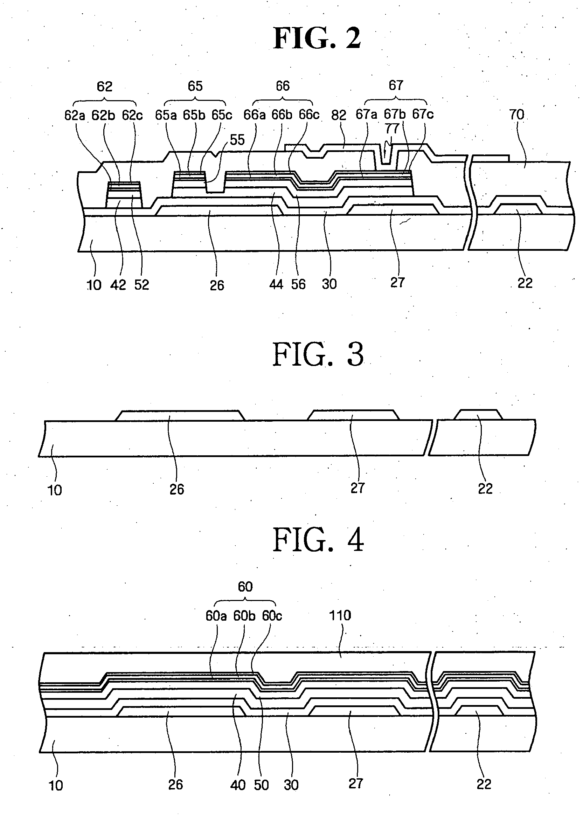

With reference to FIGS. 1 and 2, the thin film transistor substrate that is produced using the production method according to the first embodiment of the present invention will be described in detail. FIG. 1 is a layout view of a thin film transistor substrate that is produced using the method of producing the thin film transistor substrate according to embodiments of the present invention.

An insulating substrate 10 may be made of a substance having heat resistance and light transmission, for example, transparent glass or plastics.

A plurality of gate interconnections 22, 26, 27, and 28 is formed on an upper part of the insulating substrate 10 to transmit a gate signal. The gate interconnections 22, 26, 27, and 28 are composed of the gate line 22 that extends in a transverse direction, the gate electrode 26 of the thin film transistor that is connected to the gate line 22 to form a protrusion, and the storage electrode 27 and the storage electrode line 28 that are formed parallel to the gate line 22.

The storage electrode line 28 extends cross a pixel region in a transverse direction, and is connected to the storage electrode 27 which has a width larger than that of the storage electrode line 28. The storage electrode 27 overlaps a drain electrode expanded part 67 that is connected to a pixel electrode 82 as described below to form a storage capacitor for improving electric charge preservation ability. The shape and the position of the above-mentioned storage electrode 27 and the storage electrode line 28 may vary, and the storage electrode 27 and the storage electrode line 28 may not be required if the storage capacitance that is generated due to the overlapping of the pixel electrode 82 and the gate line 22 is desirably high.

The gate interconnections 22, 26, 27, and 28 may be made of an aluminum-based metal, such as aluminum (Al) and an aluminum alloy, a silver-based metal, such as silver (Ag) and a silver alloy, a copper-based metal, such as copper (Cu) or a copper alloy, a molybdenum-based metal, such as molybdenum (Mo) and a molybdenum alloy, chromium (Cr), titanium (Ti), or tantalum (Ta). Additionally, the gate interconnections 22, 26, 27, and 28 may have a multilayered structure including two conductive layers(not shown) having different physical properties. Of the two conductive layers, any one conductive layer is formed of metal having low resistivity, for example, the aluminum-based metal, the silver-based metal, or the copper-based metal, so as to reduce time delay of a signal or drop in voltage for gate interconnections 22, 26, 27, and 28.

On the other hand, another conductive layer may be formed of another substance, for example, a substance having excellent adhesion strength to ITO (indium tin oxide) and IZO (indium zinc oxide), such as the molybdenum-based metal, chromium, titanium, or tantalum. With respect to the above-mentioned combination, the structure that includes a lower chromium layer and an upper aluminum layer, or the structure that includes a lower aluminum layer and an upper molybdenum layer may be formed.

Additionally, the gate interconnections 22, 26, 27, and 28 may be formed by applying PEDOT (PolyEthyleneDiOxyThiophene), a conductive organic polymer-based substance, using a predetermined coating process, or by printing using an inject-printing process. However, the present invention is not limited thereto. The gate interconnections 22, 26, 27, and 28 may be made of various types of metals, conductors, or conductive organic polymer-based substances.

A gate insulating layer 30 that is made of an inorganic insulating substance such as silicon oxide (SiOx) or silicon nitride (SiNx), or an organic insulating substance (hydrogenated amorphous silicon) such as BCB (BenzoCycloButene), an acryl-based substance, or polyimide is formed on upper parts of the gate interconnections 22 and 26 and the insulating substrate 10.

The active layer patterns 42 and 44 that are made of hydrogenated amorphous silicon, polysilicon, or the conductive organic substance are formed on an upper part of the gate insulating layer 30.

The active layer patterns 42 and 44 may be provided to have an island shape. The active layer patterns 42 and 44 overlap the gate electrode 26 and the storage electrode 27 on the gate electrode 26, and partially overlap a source electrode 65 and a drain electrode 66 as described below. The shape of the active layer patterns 42 and 44 is not limited to the island, but the active layer patterns 42 and 44 may have various types of shapes.

Ohmic contact layers 52, 55, and 56 that are made of n+ hydrogenated amorphous silicon, such as silicide, in which an n-type impurity is doped at a high concentration, or ITO in which a p-type impurity is doped are formed on upper parts of the active layer patterns 42 and 44.

Data interconnections 62, 65, 66, and 67 are formed on upper parts of the ohmic contact layers 52, 55, and 56. The data interconnections 62, 65, 66, and 67 are composed of a data line 62 that crosses the gate line 22 in a longitudinal direction to define the pixel, the source electrode 65 that is branched from the data line 62 and extends to an upper part of the ohmic contact layer 55, a drain electrode 66 that is separated from the source electrode 65 and formed on an upper part of the ohmic contact layer 56 which is opposite to the source electrode 65 with respect to channel parts of the gate electrode 26 or the thin film transistor, and the drain electrode expanded part 67 that extends from the drain electrode 66 to overlap the storage electrode 27 and has a large area.

The data interconnections 62, 65, 66, and 67 may be made of refractory metal such as chromium, molybdenum-based metal, tantalum, and titanium. Additionally, the data interconnections 62, 65, 66, and 67 may have a multilayered structure that includes a lower refractory metal layer (not shown) and an upper layer (not shown) made of a substance having low resistance. With respect to the data interconnections 62, 65, 66, and 67 having the multilayered structure, the data interconnections 62, 65, 66, and 67 may include lower data interconnections 62a, 65a, 66a, and 67a that are made of molybdenum (Mo), intermediate data interconnections 62b, 65b, 66b, and 67b that are made of aluminum (Al), and upper data interconnections 62c, 65c, 66c, and 67c that are made of molybdenum (Mo).

The source electrode 65 overlaps at least a portion of the active layer pattern 44. The drain electrode 66 faces the source electrode 65 while the gate electrode 26 is provided between the drain electrode 66 and the source electrode 65, and overlaps at least a portion of the active layer pattern 44. In connection with this, the ohmic contact layers 55 and 56 are interposed between the active layer pattern 44 therebeneath and the source electrode 65 and the drain electrode 66 thereon to reduce contact resistance.

The drain electrode expanded part 67 is provided to overlap the storage electrode 27, and forms the storage capacitor in conjunction with the storage electrode 27 while the gate insulating layer 30 is provided between the storage electrode 27 and the drain electrode expanded part 67. When the storage electrode 27 is not formed, the drain electrode expanded part 67 may not be required.

The ohmic contact layers 52, 55, and 56 reduce contact resistance between the active layer patterns 42 and 44 therebeneath and the data interconnections 62, 65, 66, and 67 thereon. The ohmic contact layers 52, 55, and 56 have substantially the same shape as the data interconnections 62, 65, 66, and 67.

Meanwhile, the active layer patterns 42 and 44 have substantially the same shape as the data interconnections 62, 65, 66, and 67 and the ohmic contact layers 52, 55, and 56, with the exception of the channel portion of the thin film transistor. That is, the source electrode 65 and the drain electrode 66 are separated from each other at the channel portion of the thin film transistor, and the ohmic contact layer 55 that is provided under the source electrode 65 is separated from the ohmic contact layer 56 that is provided under the drain electrode 66. However, the active layer pattern 44 for the thin film transistor is not broken at the channel portion but extends through the channel portion to form the channel of the thin film transistor.

A protective layer 70 is formed on the data interconnections 62, 65, 66, and 67 and an upper part of the active layer pattern 44 which is not covered with the data interconnections 62, 65, 66, and 67. The protective layer 70 may be made of, for example, an organic substance having excellent planarization property and photosensitivity, a low dielectric insulating substance, such as a-Si:C:O or a-Si:O:F, that is formed using plasma enhanced chemical vapor deposition (PECVD), or silicon nitride (SiNx) that is an inorganic substance. Additionally, when the protective layer 70 is made of the organic substance, in order to prevent the organic substance of the protective layer 70 from coming into contact with an exposed portion of the active layer pattern 44 between the source electrode 65 and the drain electrode 66, an insulating layer (not shown) that is made of silicon nitride (SiNₓ) or silicon oxide (SiO₂) may be further formed under the organic layer.

A contact hole 77 is formed in the protective layer 70 to expose the drain electrode expanded part 67.

A pixel electrode 82 is formed on the upper part of the protective layer 70 to be electrically connected through the contact hole 77 to the drain electrode 66 and to have the corresponding position to the pixel. The pixel electrode 82 to which data voltage is applied generates an electric field in conjunction with the common electrode of the common electrode substrate to control alignment of the liquid crystal molecules of the liquid crystal layer between the pixel electrode 82 and the common electrode.

Hereinafter, a method of producing the thin film transistor substrate according to the first embodiment of the present invention will be described with reference to FIGS. 1 to 13. FIG. 2 is a sectional view of the thin film transistor substrate taken along the line A-A' of FIG. 1. FIGS. 3 to 13 are sectional views showing the production of the thin film transistor substrate according to the first embodiment of the present invention.

First, as shown in FIGS. 1 and 3, the gate interconnections 22, 26, 27, and 28 that include the gate line 22, the storage electrode 27, and the storage electrode line 28 are formed.

Subsequently, as shown in FIGS. 1 and 4, the gate insulating layer 30 that is made of silicon nitride, an active layer 40, and a doped amorphous silicon layer 50 are sequentially deposited on the gate interconnections 22, 26, 27, and 28 by using, for example, a chemical vapor deposition process to the thickness of 150 to 500nm, 50 to 200nm, and 30 to 60nm, respectively.

Subsequently, a conductive layer for data interconnection 60 is formed on the doped amorphous silicon layer 50 using a predetermined process such as sputtering. The conductive layer for data interconnection 60 according to the present embodiment includes aluminum. In detail, with respect to the conductive layer for data interconnection 60, a lower conductive layer for data interconnection 60a that is made of molybdenum, an intermediate conductive layer for data interconnection 60b that is made of aluminum, and an upper conductive layer for data interconnection 60c are sequentially layered. The conductive layer for data interconnection 60 forms the data interconnections 62, 65, 66, and 67 which are made of the above-mentioned substance by using a subsequent etching process.

Subsequently, a photoresist 110 is applied on an upper part of the above-mentioned conductive layer for data interconnection 60.

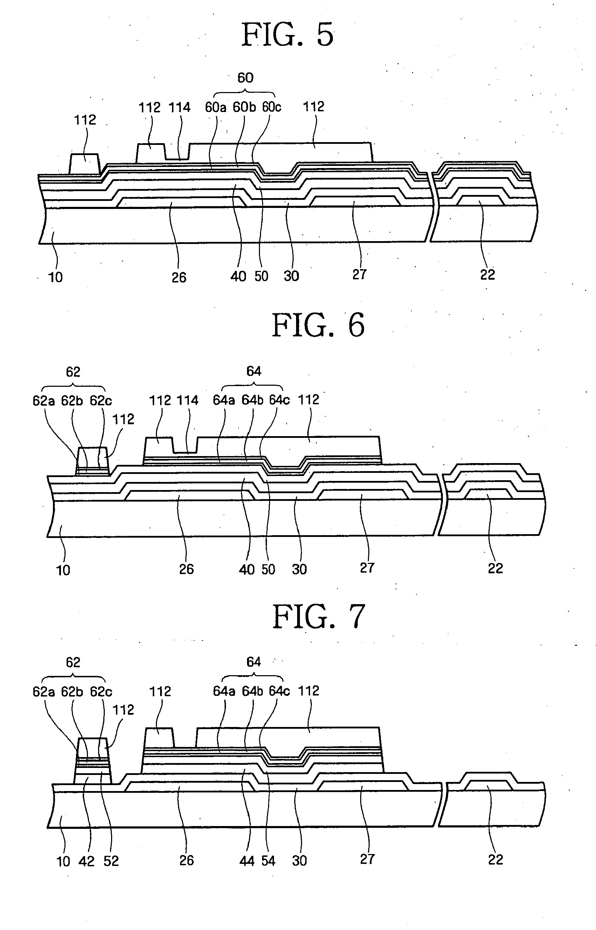

Subsequently, as shown in FIG. 5, light is radiated on the photoresist (see reference numeral 110 of FIG. 4) using a mask, and then developed to form photoresist patterns 112 and 1 14 which include a first region and a second region. In connection with this, the second region 114 of the photoresist patterns 112 and 114 that is provided in the channel portion of the thin film transistor, that is, the region between the source electrode (see reference numeral 65 of FIG. 1) and the drain electrode (see reference numeral 66 of FIG. 1) is thinner than the first region 112 which is provided in the data interconnection portion, that is, the portion on which the data interconnection is to be formed.

Additionally, a portion of the photoresist other than the channel portion and the data interconnection portion is fully removed. In connection with this, a ratio of the thickness of the second region 114 that remains on the channel portion and the thickness of the first region 112 that remains on the data interconnection portion must vary according to the process condition of the etching process as described below. It is preferable that the thickness of the second region 114 be 1/2 or less of the thickness of the first region 112. For example, the thickness of the second region 114 is preferably 400nm or less.

As described above, various types of processes may be used to control the thickness of the photoresist depending on the position. In order to control the amount of light transmitted, the pattern having a slit or lattice shape, or a semitransparent film is used.

In connection with this, the widths of the patterns that are provided between the slits, or the interval between the patterns, that is, the width of the slit, is preferably smaller as compared to resolution of an exposing device used during the exposure. When the semitransparent film is used, the thin films having different transmittances or the thin films having different thicknesses may be used to control the transmittance while the mask is being formed.

If light is radiated on the photoresist using the above-mentioned mask, polymers are fully decomposed at a portion of the photoresist that is exposed to light. However, since the amount of light which is radiated is small at the portion of the photoresist on which the slit pattern or the semitransparent film is formed, the polymers are not fully decomposed, and a few polymers are decomposed at a portion of the photoresist that is covered with a light blocking film. Subsequently, if the photoresist is developed, only the portion of the photoresist in which the polymer molecules are not decomposed remains. In the central portion to which light is radiated at the low amount, the second region 114 of the photoresist which has the thickness smaller than that of the portion to which light is not radiated may remains. In connection with this, if the exposing time is long, since all the molecules are decomposed, it is required that the exposing time be selected accordingly.

The photoresist which is made of a substance capable of performing reflow is prepared. The photoresist is exposed using a typical mask that includes a portion through which light is capable of being fully transmitted and another portion through which light is not capable of being fully transmitted. The photoresist is developed and subjected to the reflow to allow a portion of the photoresist to flow into a region in which the photoresist is not present, thereby forming the second region 114 of the photoresist having a small thickness.

Subsequently, the second region 114 and the conductive layer for data interconnection 60 that is provided under the second region are subjected to etching. The conductive layer for data interconnection 60 may be subjected to wet etching using the photoresist patterns 112 and 114 as an etching mask by means of an etching solution such as a phosphoric acid, a nitric acid, and an acetic acid.

Thereby, as shown in FIG. 6, only the data line 62, the channel portion, and the conductive layer pattern for source/drain electrode 64 remain, and the conductive layer for data interconnection (see reference numeral 60 of FIG. 5) of a portion other than the data line 62, the channel portion, and the conductive layer pattern for source/drain electrode 64 is fully removed to expose the doped amorphous silicon layer 50h. In connection with this, the residual data line 62 and conductive layer pattern for source/drain electrode 64 has the same shape as the data interconnections (see reference numerals 62, 65, 66, and 67 of FIG. 1), except that the source electrode and the drain electrode (see reference numerals 65 and 66 of FIG. 1) are not separated from each other but connected to each other. Since the data line 62 and the conductive layer pattern for source/drain electrode 64 are formed by patterning the conductive layer for data interconnection (see reference numeral 60 of FIG. 5) which has three layers, the data line 62 and the conductive layer pattern for source/drain electrode 64 include data lines 62a, 62b, and 62c composed of three layers, that is, the lower molybdenum layer, the intermediate aluminum layer, and the upper molybdenum layer, and the conductive layer patterns for source/drain electrode 64a, 64b, and 64c.

Subsequently, as shown in FIG. 7, the exposed doped amorphous silicon layer (see reference numeral 50 of FIG. 6) of the portion other than the data lines 62a, 62b, and 62c, the channel portion, and the conductive layer patterns for source/drain electrode 64a, 64b, and 64c, and the active layer (see reference numeral 40 of FIG. 6) are removed by dry etching to form the doped amorphous silicon layer patterns 52 and 54 and the active layer pattern 44. The exposed doped amorphous silicon layer and the active layer provided under the exposed doped amorphous silicon layer are etched using the photoresist patterns 112 and 114 as the etching mask. The etching is performed so that the doped amorphous silicon layer and the active layer are simultaneously etched and the gate insulating layer 30 is not etched. For example, if a mixed gas of SF₆ and HCl, or a mixed gas of SF₆ and O₂ is used, the two layers may be etched so that the etched thicknesses are almost the same.

Subsequently, the second region 1 14 of the photoresist is removed using the dry etching process. The second region 114 of the photoresist, the doped amorphous silicon layer, and the active layer may be simultaneously removed using the dry etching process.

When the etching ratio to the photoresist patterns 112 and 114, and the etching ratio to the active layer are the same as each other, it is required that the thickness of the second region 1 14 be to the same as or smaller than the sum total of the thicknesses of the active layer and the doped amorphous silicon layer. Thereby, the second region 114 provided on the channel portion is removed to expose the conductive layer pattern for source/drain electrode 64. The doped amorphous silicon layer and the active layer of the portion other than the second region 1 14 are removed to expose the gate insulating layer 30 provided under the doped amorphous silicon layer and the active layer. Meanwhile, the first region 112 of the data interconnection portion is etched to be made thin.

Subsequently, the photoresist which remains on the surface of the conductive layer pattern for source/drain electrode 64 of the channel portion is removed by ashing.

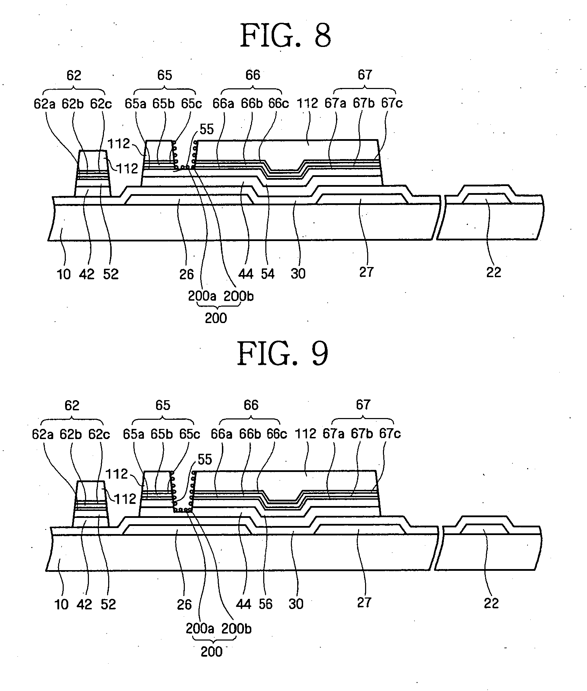

Subsequently, as shown in FIG. 8, the conductive layer pattern for source/drain electrode 64 of the channel portion, that is, the conductive layer pattern for source/drain electrode 64 provided under the second region (see reference numeral 114 of FIG. 6) of the photoresist, is subjected to dry etching so as to be removed. The conductive layer pattern for source/drain electrode 64 is subjected to the dry etching using, for example, chlorine-based etching gas. The conductive layer pattern for source/drain electrode 64 is etched using the chlorine-based etching gas to assure a desirable etch rate and etching uniformity.

This will be described in detail with reference to FIGS. 7 and 8. First, the upper conductive layer pattern for source/drain electrode 64c that is made of molybdenum is etched using the etching gas that includes SF₆ and Cl₂ as main components to form the upper source electrode 65c and the upper drain electrode 66c.

Subsequently, the intermediate conductive layer pattern for source/drain electrode 64b that is made of aluminum is etched using the etching gas that includes Cl₂ and BCl₃ as main components to form the intermediate source electrode 65b and the intermediate drain electrode 66b. The Cl₂ that is the byproduct of the reaction of the etching gas may be attached to walls of the upper source electrode 65c and the upper drain electrode 66c, walls of the intermediate source electrode 65b and the intermediate drain electrode 66b, and a wall of the first region 112 of the photoresist pattern that is adjacent to the portion on which the second region (see reference numeral 114 of FIG. 6) of the photoresist pattern is present. Additionally, Cl₂ may be reacted with water (H₂O) in the atmosphere to form HCl. Cl₂ and HCl may etch the wall of the first region 112 of the above-mentioned photoresist pattern and a portion of the upper source electrode 65c and the upper drain electrode 66c that are made of molybdenum, so that the intermediate source electrode 65b and the intermediate drain electrode 66b made of aluminum protrude from the wall of the first region 112 of the above-mentioned photoresist pattern and the upper source electrode 65c and the upper drain electrode 66c. Furthermore, since Cl₂ and HCl may corrode the intermediate source electrode 65b and the intermediate drain electrode 66b that are made of aluminum, it is necessary to rapidly remove Cl₂ and HCl. Hereinafter, in the specification, Cl₂ and HCl are referred to as reaction byproducts 200a and 200b, and a process of removing the reaction byproducts 200a and 200b will be described in detail.

Next, the lower conductive layer pattern for source/drain electrode 64a is etched using the etching gas that includes Cl₂ and O₂ as main components to form the lower source electrode 65a and the lower drain electrode 66a, thereby finishing the production of the source electrode 65 and the drain electrode 66. Since the conductive layer pattern for source/drain electrode 64 includes three types of substances, the three-layered electrodes, that is, the source electrodes 65a, 65b, and 66c and the drain electrodes 66a, 66b, and 66c, are formed.

Subsequently, as shown in FIG. 9, the ohmic contact layer pattern (see reference numeral 54 of FIG. 8) that is made of doped amorphous silicon is etched using the first region 112 of the photoresist pattern as the etching mask. In connection with this, the dry etching may be used. Examples of the etching gas may include the mixed gas of CF₄ and HCl, the mixed gas of CF₄ and O₂, or gas containing SF₆ and Cl₂ as main components. The above-mentioned gases may be used to form the active layer pattern 44 that has a uniform thickness and is made of intrinsic amorphous silicon. A portion of the active layer pattern 44 may be removed to make the active layer pattern thin. Additionally, the first region 112 of the photoresist pattern may be etched to a predetermined thickness. Preferably, the etching is performed so that the gate insulating layer 30 is not etched, and the photoresist pattern is thick so as to prevent the exposure of the data interconnections 62, 65, 66, and 67 due to the etching of the first region 112.

Thus, the source electrode 65 and the drain electrode 66 are separated from each other, thereby finishing the formation of the data interconnections 65 and 66 and the ohmic contact layers 55 and 56 provided under the data interconnections 65 and 66.

In FIGS. 7 to 9, since the process of etching the active layer (see reference numeral 40 of FIG. 6), the process of removing the second region of the photoresist pattern (see reference numeral 114 of FIG. 6), the process of dry etching the conductive layer pattern for source/drain electrode 64, and the process of etching a portion of the active layer pattern 44 are all dry etching processes, all of the processes may be performed in the same chamber.

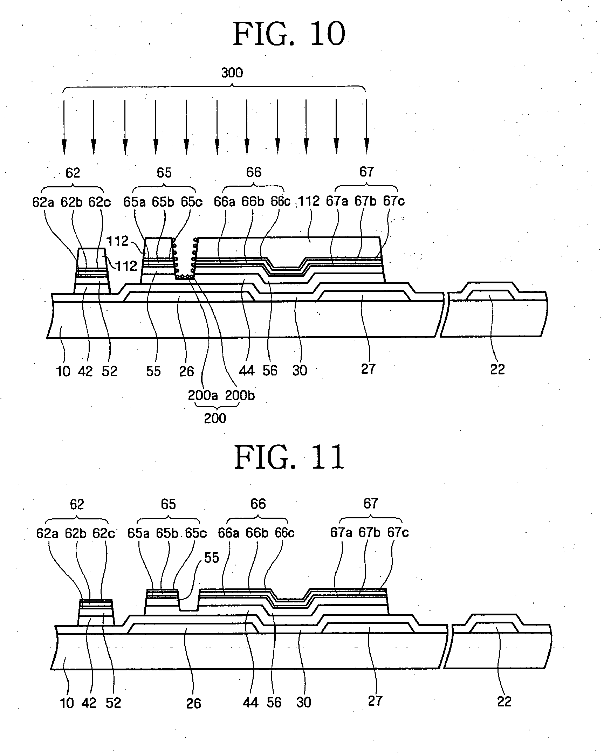

Subsequently, as shown in FIG. 10, the conductive layer pattern for the source/drain electrode (see reference numeral' 64b of FIG. 7) that is made of aluminum, and Cl₂ and HCl that are the reaction byproducts 200a and 200b of the etching gas that includes Cl₂ and BCl₃ as main components and is used to etch the conductive layer pattern for source/drain electrode, are physically removed using a reaction byproduct removal agent 300. The process of removing the reaction byproducts 200a and 200b is performed 1 5 minutes after the insulating substrate 10 that is subjected to the above-mentioned processes is drawn from the chamber.

In the process of physically removing the reaction byproducts 200a and 200b of the embodiments using the reaction byproduct removal agent 300, physical force that is applied to the reaction byproducts 200a and 200b may be obtained by spraying the reaction byproduct removal agent 300 on the reaction byproducts 200a and 200b. As described above, in the process of removing the reaction byproducts 200a and 200b, the reaction byproduct removal agent 300 is sprayed so that the physical force such as pressure is applied to the reaction byproducts 200a and 200b to remove the reaction byproducts 200a and 200b. Accordingly, in the above-mentioned process, the reaction byproducts 200a and 200b are more effectively removed as compared to the process of removing the reaction byproducts 200a and 200b in which the insulating substrate 10 having the reaction byproducts 200a and 200b is subjected to dipping without physical force. The difference in efficiency of the two processes which are compared with each other will be described in Examples and Comparative Examples.

Since the heater has limited power, in consideration of the desirable process operation and process cost, it is preferable that the temperature of the reaction byproduct removal agent 300 be 25°C or more and less than 60°C. However, the reaction byproduct removal agent 300 may be sprayed at the higher temperature. That is, the reaction byproduct removal agent 300 may be sprayed at various temperatures. The spraying temperature of the reaction byproduct removal agent 300 depends on the delay time that is taken to perform the spraying of the reaction byproduct removal agent 300 after the insulating substrate 10 is drawn from the chamber. In detail, when the spraying temperature of the reaction byproduct removal agent 300 is about 25°C, it is required that the delay time is in the range of 5 minutes or less so as to effectively remove the reaction byproducts 200a and 200b. When the temperature of the spraying of the reaction byproduct removal agent 300 is about 50°C, it is required that the delay time is in the range of 15 minutes or less so as to effectively remove the reaction byproducts 200a and 200b. The spraying temperature and the delay time of the reaction byproduct removal agent 300 are controlled in consideration of the above-mentioned description.

The reaction byproducts 200a and 200b are rinsed to remove the sprayed reaction byproduct removal agent 300. However, the reaction byproduct removal agent 300 that does not etch the source electrode 65 and the drain electrode 66 made of the same substance as the conductive layer pattern for source/drain electrode 64 is used so as to prevent the source electrode 65 and the drain electrode 66 from being removed in the course of rinsing the reaction byproducts. Preferably, deionized water (DIW) is used as the reaction byproduct removal agent 300.

In the process of removing the reaction byproducts 200a and 200b, the spraying pressure and the spraying time of the reaction byproduct removal agent 300 may be one of the important factors of effectively removing the reaction byproducts 200a and 200b. In detail, the spraying pressure of the reaction byproduct removal agent 300 may be 1 to 5 kgf/cm². It is preferable that the reaction byproduct removal agent 300 be sprayed for 10 seconds or more and less than 3 minutes. When the spraying pressure and the spraying time are not in the above-mentioned range, the reaction byproducts 200a and 200b may be undesirably removed, or damage to the source electrode 65 and the drain electrode 66 may occur during the removal of the reaction byproducts 200a and 200b.

Needless to say, the reaction byproducts 200a and 200b that are removed by the above processes include Cl₂ or HCl which corrodes aluminum of the three-layered source electrode 65 and the three-layered drain electrode 66.

As described above, since the reaction byproducts 200a and 200b which are attached to the source electrode 65 and the drain electrode 66 are removed, the source electrode 65b and the drain electrode 66b that are made of aluminum among the three-layered source electrodes 65a, 65b, and 65c and the three-layered drain electrodes 66a, 66b, and 66c are not corroded even though the reaction byproduct comes into contact therewith.

Subsequently, as shown in FIG. 11, the photoresist the first region 112 that remains on the data interconnection part is stripped to be removed.

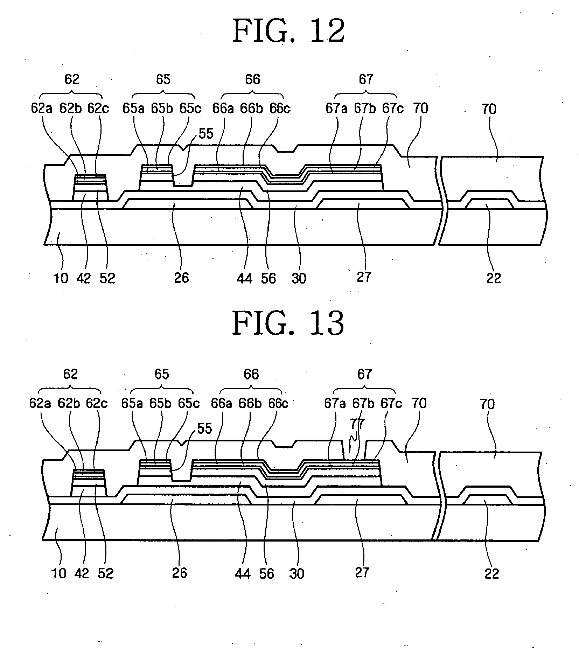

Subsequently, as shown in FIG. 12, a protective layer 70 is formed on the resulting structure.

Subsequently, as shown in FIG. 13, the protective layer 70 is subjected to a photolithography process in conjunction with the gate insulating layer 30 to form a contact hole 77 through which a drain electrode expanded part 67 is exposed.

Finally, as shown in FIGS. 1 and 2, the ITO layer is deposited to have a thickness in the range of 40 to 50nm, and then subjected to the photolithography process to form a pixel electrode 82 which is connected to a drain electrode expanded part 67. Thereby, the thin film transistor substrate 1 is created.

Meanwhile, it is preferable that nitrogen be used as gas applied to the pre-heating process before the ITO is layered in order to prevent a metal oxide layer from being formed on an upper part of the metal layer 67 which is exposed through the contact hole 77.

Hereinafter, the process of removing the reaction byproducts 200a and 200b using the spraying of the reaction byproduct removal agent 300 according to Examples of the present invention, and the process of removing the reaction byproducts 200a and 200b by dipping will be compared in views of removal efficiency in Examples and Comparative examples with reference to FIGS. 9 and 10.

### (EXPERIMENTAL EXAMPLE 1)

As shown in FIG. 9, immediately after the insulating substrate 10 that was subjected to the process of dry etching the conductive layer pattern for source/drain electrode 64 and the process of etching a portion of the active layer pattern 44 was drawn from the chamber, the reaction byproduct removal agent 300 was sprayed on the insulating substrate 10 using a washing device (not shown) as shown in FIG. 10. The spraying pressure of the reaction byproduct removal agent 300 was 1 kgf/cm², and the spraying time of the reaction byproduct removal agent is 60 seconds. The temperature of the reaction byproduct removal agent 300 was set to 50°C. Subsequently, the number of reaction byproducts 200a and 200b per unit area of the insulating substrate 10 was measured, and the results are described in Table 1.

### (EXPERIMENTAL EXAMPLE 2)

The test of Experimental EXAMPLE 1 was repeated except that the insulating substrate 10 was drawn from the chamber, and, after 1 5 minutes, the reaction byproduct removal agent 300 was sprayed on the insulating substrate 10.

### (EXPERIMENTAL EXAMPLE 3)

The test of Experimental EXAMPLE 1 was repeated except that the temperature of the reaction byproduct removal agent 300 was set to 25°C.

### (EXPERIMENTAL EXAMPLE 4)

The test of Experimental EXAMPLE 1 was repeated except that the insulating substrate 10 was drawn from the chamber, after 1 5 minutes, the reaction byproduct removal agent 300 was sprayed on the insulating substrate 10, and the temperature of the reaction byproduct removal agent 300 was set to 25°C.

### (COMPARATIVE EXAMPLE 1)

The test of Experimental EXAMPLE 1 was repeated except that the insulating substrate 10 was dipped in the reaction byproduct removal agent 300 at the temperature of 50°C.

### (COMPARATIVE EXAMPLE 2)

The test of Experimental EXAMPLE 1 was repeated except that the insulating substrate 10 was drawn from the chamber, and, after 1 5 minutes, the insulating substrate 10 was dipped in the reaction byproduct removal agent 300 at the temperature of 50°C.

### (COMPARATIVE EXAMPLE 3)

The test of Experimental EXAMPLE 1 was repeated except that the insulating substrate 10 was dipped in the reaction byproduct removal agent 300 at the temperature of 25°C.

### (COMPARATIVE EXAMPLE 4)

The test of Experimental EXAMPLE 1 was repeated except that the insulating substrate 10 was drawn from the chamber, and, after 1 5 minutes, the insulating substrate 10 was dipped in the reaction byproduct removal agent 300 at the temperature of 25°C.

**[Table 1]**

| | Reaction byproducts 200a and 200b per unit area |
|---|---|
| Experimental Example 1 | less than 3 |
| Experimental Example 2 | less than 3 |
| Experimental Example 3 | less than 3 |
| Experimental Example 4 | less than 10 |
| Comparative Example 1 | less than 10 |
| Comparative Example 2 | Countless |
| Comparative Example 3 | Countless |
| Comparative Example 4 | Countless |

As shown in the above-mentioned Table 1, when the temperature of the reaction byproduct removal agent 300 and the delay time which is taken to bring the reaction byproduct removal agent 300 into contact with the insulating substrate 10 after the insulating substrate 10 was drawn from the chamber were constant, the number of the reaction byproducts 200a and 200b that are present on the insulating substrate 10 after the washing was smaller in the present Experimental Example 1 where the reaction byproduct removal agent 300 was sprayed on the insulating substrate 10 compared to when the insulating substrate 10 was dipped in the reaction byproduct removal agent 300. Accordingly, it can be seen that the process of spraying the reaction byproduct removal agent 300 to remove the reaction byproducts 200a and 200b according to the present Experimental example is more effective than the process of simply dipping the insulating substrate 1 0 having the reaction byproducts 200a and 200b in the reaction byproduct removal agent 300 in views of washing ability.

In the method of producing the thin film transistor substrate according to the first embodiment of the present invention, the corrosion of aluminum due to the reaction byproduct which is generated during the process of dry etching the source electrode 65 and the data electrode 66 that are made of aluminum may be prevented. Thus, it is possible to prevent the source electrode 65 and the data electrode 66 from being corroded.

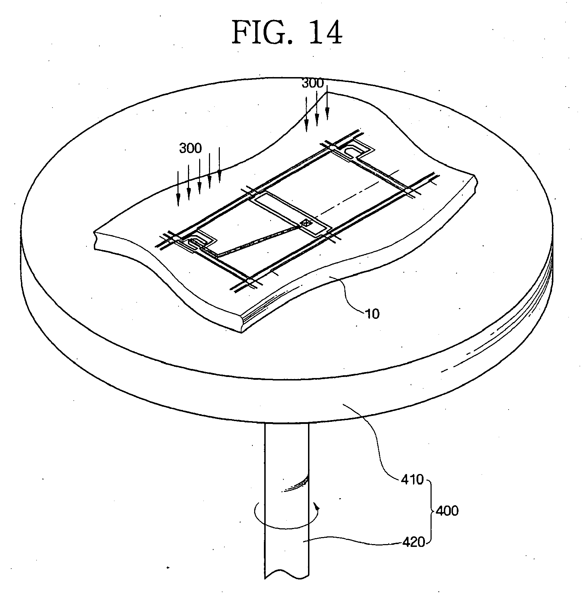

Hereinafter, a method of producing the thin film transistor substrate according to the second embodiment of the present invention will be described in detail with reference to FIGS. 1 to 9 and 11 to 14. FIG. 14 schematically shows the production of the thin film transistor substrate according to the second embodiment of the present invention. For convenience of description, the members that have the same function as the members shown in the drawings of the former embodiment are referred to as the same reference numerals, and the description thereof will be omitted or briefly given.

In the method of producing the thin film transistor according to the present embodiment, the gate interconnections 22, 26, 27, and 28, the gate insulating layer 30, the active layer patterns 42 and 44, the ohmic contact layers 55 and 56, the source electrode 65, and the drain electrode 66 are sequentially formed on the insulating substrate 10 using the processes shown in FIGS. 3 to 9.

In the course of forming the three-layered source electrodes 65a, 65b, and 65c and the three-layered drain electrodes 66a, 66b, and 66c like the former embodiment, dry etching gas of the intermediate conductive layer pattern for source/drain electrode 64b that is made of aluminum, and the reaction byproducts 200a and 200b of the conductive layer pattern for source/drain electrode 64b are generated. Since the dry etching gas and the reaction byproducts 200a and 200b may corrode the source electrode 65b and the drain electrode 66b which are made of aluminum, the dry etching gas and the reaction byproducts are removed during the subsequent process.

With reference to FIG. 14, in the process of physically removing the reaction byproducts 200a and 200b using the reaction byproduct removal agent 300 according to the present embodiment, physical force that is applied to the reaction byproducts 200a and 200b may be obtained by rotating the insulating substrate 10 that is formed on the above source electrode 65b and the drain electrode 66b and provided on a mounting plate 410 of a spinner 400. Additionally, the reaction byproduct removal agent 300 having a predetermined temperature may be sprayed on the reaction byproducts 200a and 200b at a predetermined pressure. That is, in the process of removing the reaction byproducts 200a and 200b according to the present embodiment, the physical force that is applied to the reaction byproducts 200a and 200b is formed by rotational force of a rotation shaft 420 of the spinner 400 and the spraying pressure. The process of spraying the reaction byproduct removal agent 300 while the insulating substrate 10 rotates is performed for the delay time of 15 minutes after the insulating substrate 10 is drawn from the chamber. The delay time may depend on the temperature of the reaction byproduct removal agent 300.

In the process of removing the reaction byproducts 200a and 200b according to the present embodiment, the rotation speed of the spinner 400, the temperature of the reaction byproduct removal agent 300, the spraying pressure, and the spraying time are controlled so that the optimum removal efficiency of the reaction byproducts 200a and 200b is assured and damage to the source electrode 65 and the drain electrode 66 does not occur.

The reaction byproducts 200a and 200b are removed using the above process to prevent the source electrode 65b and the drain electrode 66b which include aluminum from being corroded.

Subsequently, as shown in FIGS. 11 to 13, the first region 112 of the photoresist pattern is stripped to be removed, and the protective layer 70 and the contact hole 77 are formed on the insulating substrate 10.

Finally, as shown in FIGS. 1 and 2, the pixel electrode 82 is formed to complete the production of the thin film transistor.

In the method of producing the thin film transistor substrate according to the second embodiment of the present invention, the corrosion of aluminum due to the reaction byproduct which is generated during the process of dry etching the source electrode 65 and the data electrode 66 that include aluminum is easily prevented. Thus, the source electrode 65 and the data electrode 66 may be prevented from being corroded.

Although the present invention has been described in connection with the exemplary embodiments of the present invention, it will be apparent to those skilled in the art that various modifications and changes may be made thereto without departing from the scope and spirit of the invention. Therefore, it should be understood that the above embodiments are not limitative, but illustrative in all aspects.

As described above, the method of producing the thin film transistor substrate according to the embodiments of the present invention has the following advantages.

First, it is possible to prevent the corrosion of the source electrode and the data electrode due to the reaction byproducts during the dry etching process.

Second, since the source electrode and the data electrode is formed using the dry etching process, the skew of the electrodes can be prevented.

Third, since the source electrode and the data electrode are prevented from being corroded, it is possible to produce a liquid crystal display having high resolution.

## Claims

1. A method of producing a thin film transistor substrate, comprising:
sequentially forming on an insulating substrate a gate interconnection, a gate insulating layer, an active layer, a conductive layer for a data interconnection, and a photoresist pattern including a first region and a second region;
etching the conductive layer by using the photoresist pattern as an etching mask to form a conductive layer pattern for source/drain electrodes and a data line;
etching the active layer by using the photoresist pattern as the etching mask to form an active layer pattern;
removing the second region of the photoresist pattern;
dry etching the conductive layer pattern for the source/drain electrodes under the second region by using the photoresist pattern as the etching mask and etching gas;
etching a portion of the active layer pattern by using the photoresist pattern as the etching mask; and
physically removing the reaction byproduct by using a reaction byproduct removal agent so that external force is applied to the etching gas and the reaction byproduct of the conductive layer pattern for the source/drain electrodes.

2. The method of claim 1, wherein the removing of the reaction byproduct includes spraying the reaction byproduct removal agent on the reaction byproduct.

3. The method of claim 2, wherein a spraying pressure of the reaction byproduct removal agent is 1 to 5 kgf/cm².

4. The method of claim 2, wherein the removing of the reaction byproduct includes spraying the reaction byproduct removal agent for 10 seconds or more and less than 3 minutes.

5. The method of claim 2, wherein the insulating substrate rotates while the reaction byproduct removal agent is sprayed.

6. The method of claim 1, wherein the reaction byproduct is Cl₂ or HCl.

7. The method of claim 1, wherein the etching gas is a chlorine-based etching gas.

8. The method of claim 1, wherein the reaction byproduct removal agent does not etch the conductive layer pattern for the source/drain electrodes.

9. The method of claim 8, wherein the reaction byproduct removal agent is deionized water.

10. The method of claim 1, wherein the etching of the active layer, the removing of the second region of the photoresist pattern, the dry etching of the conductive layer pattern for the source/drain electrodes, and the etching of the portion of the active layer pattern are performed in the same chamber.

11. The method of claim 10, wherein the temperature of the reaction byproduct removal agent is 25°C or more and less than 60°C.

12. The method of claim 11, wherein the removing of the reaction byproduct is performed for 1 5 minutes after the insulating substrate is drawn from the chamber.

13. The method of claim 1, wherein the conductive layer for data interconnection includes aluminum.

14. The method of claim 13, wherein the conductive layer for data interconnection has a multilayered structure in which molybdenum, aluminum, and molybdenum is sequentially layered.

15. The method of claim 14, wherein the reaction byproduct removed using the reaction byproduct removal agent is Cl₂ or HCl corroding aluminum.

16. The method of claim 1, further comprising:
stripping the photoresist pattern; and
forming a protective layer and a pixel electrode, after the removing of the reaction byproduct.

17. A method of producing a thin film transistor substrate, comprising:
sequentially forming on an insulating substrate a gate interconnection, a gate insulating layer, an active layer, a conductive layer for a data interconnection including aluminum, and a photoresist pattern including a first region and a second region;
etching the conductive layer by using the photoresist pattern as an etching mask to form a conductive layer pattern for source/drain electrodes;
etching the active layer by using the photoresist pattern as the etching mask to form an active layer pattern;
removing the second region of the photoresist pattern;
dry etching the conductive layer pattern for the source/drain electrodes under the second region by using the photoresist pattern as the etching mask and chlorine-based etching gas;
etching a portion of the active layer pattern by using the photoresist pattern as the etching mask; and
spraying a reaction byproduct removal agent at a temperature of 25°C or more and less than 60°C onto the etching gas and the reaction byproduct of the conductive layer pattern for the source/drain electrodes to remove the reaction byproduct.

18. The method of claim 17, wherein:
the etching of the active layer, the removing of the second region of the photoresist pattern, the dry etching of the conductive layer pattern for the source/drain electrodes, and the etching of the portion of the active layer pattern are performed in the same chamber; and
the removing of the reaction byproduct is performed for 15 minutes after the insulating substrate is drawn from the chamber.

19. The method of claim 17, wherein the data interconnection has a multilayered structure in which molybdenum, aluminum, and molybdenum is sequentially layered.
